**Europäisches Patentamt**

**European Patent Office**

**Office européen des brevets**

(19)

(11) Veröffentlichungsnummer : **0 200 054**
**B1**

(12) # EUROPÄISCHE PATENTSCHRIFT

(45) Veröffentlichungstag der Patentschrift :
**07.03.90**

(51) Int. Cl.⁵ : **H 05 K   9/00**

(21) Anmeldenummer : **86104959.1**

(22) Anmeldetag : **11.04.86**

(54) **Kontaktvorrichtung für geschirmte Kabinen und Räume mit HF-dicht geschirmten, gegeneinander beweglichen Gehäuseteilen.**

(30) Priorität : **12.04.85 DE 3513186**

(43) Veröffentlichungstag der Anmeldung :
**05.11.86 Patentblatt 86/45**

(45) Bekanntmachung des Hinweises auf die Patenterteilung : **07.03.90 Patentblatt 90/10**

(84) Benannte Vertragsstaaten :
**BE DE FR GB IT NL**

(56) Entgegenhaltungen :
**EP–A– 0 095 743**
**DE–A– 2 601 277**
**DE–B– 2 451 192**
**US–A– 3 277 230**
**US–A– 3 304 360**

(73) Patentinhaber : **Siemens Aktiengesellschaft**
**Wittelsbacherplatz 2**
**D-8000 München 2 (DE)**

(72) Erfinder : **Bienia, Richard**
**Sudetenweg 5**
**D-8411 Wenzenbach (DE)**
Erfinder : **Schaller, Rudolf, Dipl.-Ing. (FH)**
**Süding 17**
**D-8401 Alteglofsheim (DE)**

## Beschreibung

Die Erfindung betrifft eine Kontaktvorrichtung für abgeschirmte Kabinen und Räume mit HF-dicht abgeschirmten, gegeneinander beweglichen Gehäuseteilen, insbesondere Türzargen, Türblätter, Fensterflügel und Fensterrahmen, die sich in ihren Randbereichen überlappen und in ihren im Randbereich der Gehäuseteile angeordneten Kontaktbereichen durch ein erstes Kontaktsystem, insbesondere ein Messerkontaktsystem mit einem messerartigen Fortsatz an dem einen Gehäuseteil und Kontaktfedern an dem anderen Gehäuseteil, die in Kontaktstellung ineinandergreifen, und zusätzlich durch ein im Überlappungsbereich der Gehäuseteile angeordnetes zweites Kontaktsystem geschirmt sind, das gegenüber dem ersten Kontaktsystem nach außen versetzt ist und insbesondere in den Eckbereichen eine durchlaufende Kontaktierung gewährleistet.

Eine Kontaktvorrichtung dieser Art ist z. B. durch die Europäische Patentanmeldung Nr. 0095743 bekannt.

In der Fernmelde- und Hochfrequenztechnik ist es grundsätzlich wichtig, die Ausbreitung elektrischer und magnetischer Felder in bestimmte Raumbereiche zu verhindern, in denen sie störende Wirkung ausüben können. Es ist daher häufig erforderlich, einzelne elektrische Geräte, z. B. Rundfunkempfänger oder empfindliche Meßgeräte, vor elektrischen Störeinflüssen durch Einbau in abschirmende Kabinen oder Käfige zu schützen oder auch ganze Räume abgeschirmt auszustatten. Elektrostatische Felder können durch dünne Metallfolien vollkommen abgeschirmt werden, während magnetostatische Felder in Räumen mit Wänden aus ferromagnetischen Materialien abgeschwächt werden.

Da die Abschirmung an Kontaktständern zwischen festen und beweglichen und zwischen gegeneinander beweglichen Raumabschirmungen, z. B. zwischen Fensterrahmen und Fensterflügeln, zwischen Türzargen und Türblättern, bzw. zwischen zwei Fensterflügeln oder Türblättern geringer ist als an lückenlosen Wandfeldern, stellen diese Kontaktstellen im allgemeinen die dämpfungsärmsten Bereiche dar. Es besteht daher immer wieder die Forderung, diese Kontaktbereiche den jeweiligen Gegebenheiten anzupassen und die Abschirmung in diesen Bereichen zu verbessern.

Entscheidend, und zwar insbesondere bei hohen, im MHz-GHz-Bereich auftretenden Frequenzen ist dabei, daß diese Kontaktvorrichtungen möglichst lückenlos in den Bereichen sämtlicher Schließkanten der Gehäuseteile, z. B. der Türen mit den Zargen, die Rahmen der gegeneinander bewegten Gehäuseteile einwandfrei kontaktieren. Besonders bei zwei Flügeltüren treten Kontaktprobleme im Bereich der Hauptschließkante, d. h. im Bereich der Berührungskante zwischen dem Geh- und Standflügel und dem Tür-Schwellen bzw. dem Tür-Sturz-Bereich auf. Hier entstehen Spalten von einigen mm Breite, die durch die meisten der bislang bekannten Kontaktvorrichtungen und insbesondere durch die bislang bekannten Kontaktfedervorrichtungen nicht überbrückt und verschlossen werden konnten. Die Folge ist, daß die Abschirmwirkung im hohen Frequenzbereich verringert ist. Lediglich die eingangs genannte bekannte Kontaktvorrichtung nach der europäischen Patentanmeldung Nr. 0095743 trägt bereits Ansätze für eine befriedigende Lösung des Problems.

Die vorliegende Erfindung hat sich die Aufgabe gestellt, eine Kontaktvorrichtung auf der Grundlage der eingangs genannten europäischen Patentanmeldung zu schaffen, die gegenüber dieser hinsichtlich ihrer Dämpfungs- bzw. Abschirmungseigenschaften und auch hinsichtlich ihres konstruktiven Aufbaus weiter verbessert ist.

Zur Lösung dieser Aufgabe sieht die Erfindung bei einer Kontaktvorrichtung der eingangs genannten Art vor, daß im Bereich zwischen den beiden Kontaktsystemen elastisches Absorbermaterial angeordnet ist, das auf einem der gegeneinander beweglichen Gehäuseteile befestigt ist, und daß als Träger des zweiten Kontaktsystems und eines Teils des ersten Kontaktsystems ein an dem einen Gehäuseteil befestigter umlaufender Versteifungsrahmen vorgesehen ist, der sich in seinem Randbereich mit dem anderen Gehäuseteil überlappt.

Als zweites Kontaktsystem können bandförmig zusammengefaßte Kontaktfedern, ein bandförmiges Metallgeflecht oder auch ein elastisch leitfähiges Band vorgesehen sein, die längs den an sich ungenügend HF-dicht abgedichteten Spalten und insbesondere auch in den Eckbereichen durchlaufend angeordnet sind.

Durch das zwischen den beiden Kontaktsystemen angeordnete elastische Absorbermaterial wird eine zusätzliche, sämtliche z. B. durch die Fertigung bedingte Unregelmäßigkeiten ausgleichende Abschirmung geschaffen. Der Versteifungsrahmen gewährleistet schließlich die notwendige Stabilität der Kontaktelemente der einzelnen Kontaktsysteme zueinander.

Die Erfindung wird nachstehend anhand eines Ausführungsbeispieles näher erläutert. Es zeigt:

Fig. 1 in teils geschnittener und gebrochener Ansicht eine zweiflügelige Tür mit einer Kontaktvorrichtung nach der Erfindung,

Fig. 2 in teils gebrochener Darstellung eine weitere Ansicht des Gehflügels nach Fig. 1 mit der Kontaktvorrichtung nach der Erfindung.

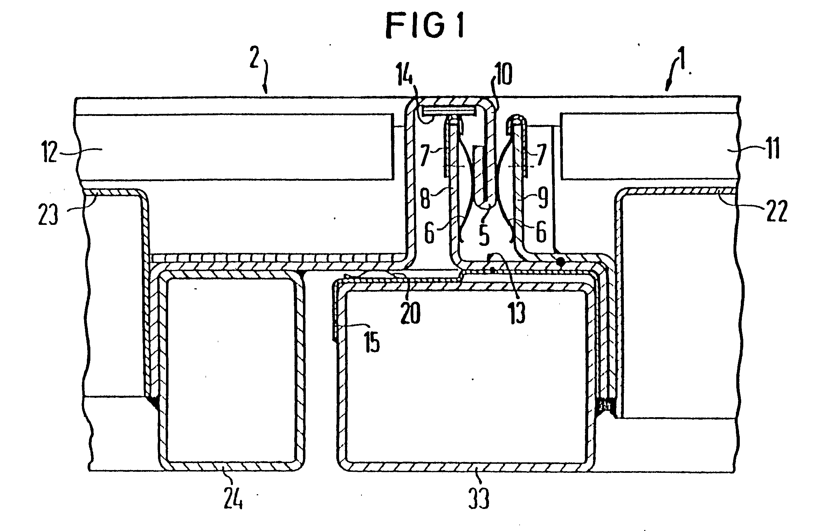

Die zweiflügelige Türe nach Fig. 1 besitzt Geh- und Stardflügel 1, 2 die z. B. mit Mineralwolle gefüllte Rahmenelemente 22, 23, Deckbleche 11, 12 und umlaufende Versteifungsrahmen 24, 33 mit rechteckförmigem Querschnitt aufweisen. Der Versteifungsrahmen 33 ist bei gleichzeitiger Verkürzung des Versteifungsrahmens 24 des Standflügels 2 in Richtung zum Standflügel 2 verlängert. Hierdurch wird in den Bereichen der Berührungskanten der beiden Flügel eine Überlappung geschaffen, welche die Anordnung eines zweiten Kontaktsystems zwischen den gegeneinander beweglichen Gehäuseteilen, d. h. zwischen den Flügeln und auch zwischen den Flügeln und den Türzargen erleichtert.

Die HF-dichte erste Kontaktvorrichtung für diese zweiflügelige Tür besteht aus einem messerartigen Fortsatz 5, der in Schließstellung der Türe in eine Nut 13 hineinragt und beidseitig gegen Kontaktfedern anliegt, die zu Kontaktfederleisten 6, 6 zusammengefaßt sind. Diese Kontaktfedern besitzen einen guten elektrischen Kontakt mit der Nut 13, sind in Richtung zum messerartigen Fortsatz 5 gewölbt und werden unter der Wirkung von z. B. hakenförmigen Klemmelementen 7, 7 gegen die Seitenwände 8 bzw. 9 der Nut 13 gepreßt. Die Seitenwände 8, 9 der Nut 13 und der messerartige Fortsatz 5 sind jeweils durch entsprechend profilierte Blattbleche gebildet, deren von der Kontaktvorrichtung abgekehrte Enden im gezeigten Ausführungsbeispiel zwischen die Versteifungsrahmen 24 bzw. 33 und die Rahmenelemente 23 bzw. 22 geklemmt und mit diesen HF- dicht verschweißt sind.

In Schließstellung der Türe liegt die Seitenwand 8 der Nut 13 mit ihen Klemmelementen 7 gegen einen dämpfend wirkenden, am Blattblech 10 befestigten Anschlag 14 an. Zur Verbesserung der Dämpfungseigenschaften ist das Material dieses Anschlages aus elastischem, bandförmigem HF-Absorbermaterial, z. B. aus elektrisch leitendem Schaumgummi gefertigt.

Das zweite, gegenüber dem ersten Kontaktsystem nach außen versetzte und durch die Versteifungsrahmen 33 getragene Kontaktsystem kann z. B. eine fortlaufende Kontaktfederleiste 20 sein, die mittelbar über ein Profilblech 15 am Versteifungsrahmen 33 befestigt ist.

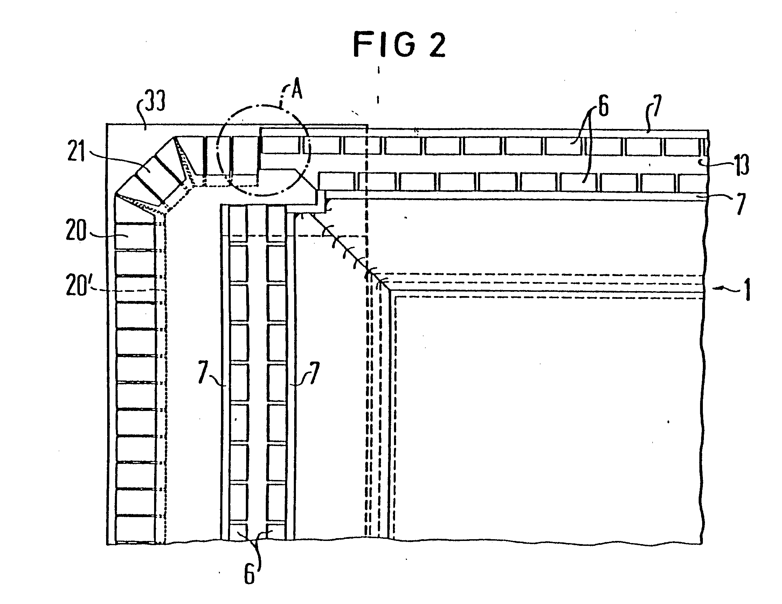

Aus Fig. 2, in der zur Veranschaulichung der Standflügel 2 nicht dargestellt ist, ist erkennbar, daß die Kontaktfederleiste 20 in der strichliniert angedeuteten Schließstellung 20' auch im Eckbereich 21 eine vollständige Kontaktierung und damit Abschirmung ermöglicht.

Im gezeigten Ausführungsbeispiel ist das zweite Kontaktsystem gegen das erste geführt (siehe Bereich A). Denkbar und zwar ohne erheblichen konstruktiven Mehraufwand, ist auch eine umlaufende Anordnung des zweiten Kontaktsystems und damit auch eine Kontaktierung in den Bereichen der Nebenschließkanten der Türen. Falls erforderlich kann die Kontaktfeder leiste 20 durch ein bandförmiges Metallgeflecht oder durch ein elastisches leitfähiges Band ersetzt sein.

Diese Kontaktvorrichtung genügt bei tieferen und mittleren Frequenzen den an sie gestellten Forderungen hinsichtlich der Abschirmung, sie erfüllt diese Forderung aber auch bei hohen Frequenzen, d. h. im MHz/GHz-Bereich. So ist z. B. im Bereich der Hauptschließkante, d. h. der Berührungskante zwischen dem Geh- und Standflügel 1 bzw. 2 im Bereich der Nebenschließkanten, d. h. im Bereich der Berührungskanten zwischen der Türe und den Türschwellen und der Türe bzw. dem Türsturz und auch in den Bereichen der Türecken eine weitgehend lückenlose Kontaktierung der gegeneinander geführten Türelemente gewährleistet. Das zwischen den beiden Kontaktsystemen angeordnete elastische Absor- bermaterial vervollständigt dabei die Abschir- mung.

## Patentansprüche

1. Kontaktvorrichtung für abgeschirmte Kabinen und Räume mit HF-dicht abgeschirmten, gegeneinander beweglichen Gehäuseteilen, insbesondere Türzargen, Türblätter, Fensterflügel und Fensterrahmen, die sich in ihren Randbereichen überlappen und in ihren im Randbereich der Gehäuseteile angeordneten Kontaktbereichen durch ein erstes Kontaktsystem, insbesondere ein Messerkontaktsystem mit einem messerartigen Fortsatz an dem einen Gehäuseteil und Kontaktfe- dern an dem anderen Gehäuseteil, die in Kontaktstellung ineinandergreifen, und zusätzlich durch ein im Überlappungsbereich der Gehäuseteile angeordnetes zweites Kontaktsystem abgeschirmt sind, das gegenüber dem ersten Kontaktsystem nach außen versetzt ist und insbesondere in den Eckbereichen eine durchlaufende Kontaktierung gewährleistet, dadurch gekennzeichnet, daß im Bereich zwischen den beiden Kontaktsystemen (5, 6, 6 bzw. 20) elastisches HF-Absorbermaterial (14) angeordnet ist, das auf einem der gegeneinander beweglichen Gehäuseteile (1, 2) befestigt ist und daß als Träger des zweiten Kontaktsystems (20) und eines Teils des ersten Kontaktsystems (5, 6, 6) ein an dem einen Gehä- useteil (1) befestigter umlaufender Versteifungs- rahmen (33) vorgesehen ist, der sich in seinem Randbereich mit dem anderen Gehäuseteil (2) überlappt.

2. Kontaktvorrichtung nach Anspruch 1, dadurch gekennzeichnet, daß als zweites Kontaktsy- stem bandförmig zusammengefaßte Kontaktfe- dern, insbesondere Kontaktfederleisten (20) vor- gesehen sind.

3. Kontaktvorrichtung nach Anspruch 1, dadurch gekennzeichnet, daß als zweites Kontaktsystem ein bandförmiges Metallgeflecht vorgesehen ist.

4. Kontaktvorrichtung nach Anspruch 1, dadurch gekennzeichnet, daß als zweites Kontaktsystem ein elastisches leitfähiges Band vorgesehen ist.

## Claims

1. Contacting arrangement for shielded cabins and spaces with HF-tight shielded housing components, which are movable in relation to each other, in particular door frames, door leaves, window wings and window frames, which overlap at their edge regions and which are shielded in their contact regions, arranged in the edge region of the housing components, by a first contact system, in particular a knife-contact system having a knife-like extension on the one housing component and contact springs on the other housing component, which engage in each other in the contact position, and in addition by a second contact system arranged in the overlapping region of the housing components, which second contact system is displaced outwards with respect to the first contact system and ensures, in particular in the corner regions, a continuous contact, characterized in that, in the region between the two contact systems (5, 6, 6 or 20) there is arranged elastic HF-absorbing material (14) which is fastened on one of the housing components (1, 2) which are movable in relation to each other, and in that as carrier of the second contact system (20) and of a part of the first contact system (5, 6, 8) an encompassing stiffening frame (33) is provided which is fastened to the one housing component (1) and which overlaps at its edge region with the other housing component (2).

2. Contacting arrangement according to Claim 1, characterized in that as a second contact system tape-shaped combined contact springs, in particular contact spring strips (20), are provided.

3. Contacting arrangement according to Claim 1, characterized in that as a second contact system a tape-shaped metal mesh is provided.

4. Contacting arrangement according to Claim 1, characterized in that as a second contact system an elastic conductive tape is provided.

**Revendications**

1. Dispositif de contact pour des cabines et pièces blindées comportant des éléments d'enceinte mobiles les uns par rapport aux autres et blindées de manière à être étanches à la haute fréquence, notamment des huisseries de portes, des ventaux de portes, des battants de fenêtres et des cadres de fenêtres, qui se chevauchent au niveau de leurs parties marginales et dont les zones de contact, situées dans la partie marginale des éléments d'enceinte, sont blindées au moyen d'un premier système de contact, notamment un système de contact à couteau comportant un prolongement en forme de couteau situé sur un élément d'enceinte et des ressorts de contact situé sur l'autre élément d'enceinte, le prolongement et les ressorts engrenant réciproquement dans la position de contact, et, en outre, par un second système de contact qui est disposé dans la zone de recouvrement des éléments d'enceinte, et qui est décalé vers l'extérieur par rapport au premier système de contact et garantit un contact continu, notamment dans les zones d'angle, caractérisé par le fait que dans la zone située entre les deux systèmes de contact (5, 6, 6 ou 20) se trouve disposé un matériau élastique (14) absorbant les hautes fréquences, qui est fixé sur l'un des éléments d'enceinte (1, 2), qui sont mobiles l'un par rapport à l'autre, et qu'il est prévu, comme support du second système de contact (20) et d'une partie du premier système de contact (5, 6, 6), un cadre périphérique de renforcement (33), qui est fixé sur un élément d'enceinte (1) et, dans sa partie marginale, est en chevauchement avec l'autre élément d'enceinte (2).

2. Dispositif de contact suivant la revendication 1, caractérisé par le fait qu'il est prévu, comme second système de contact, des ressorts de contact réunis pour former une bande, notamment des barrettes élastiques de contact (20).

3. Dispositif de contact suivant la revendication 1, caractérisé par le fait qu'il est prévu, comme second système de contact, une tresse métallique en forme de bande.

4. Dispositif de contact suivant la revendication 1, caractérisé par le fait qu'il est prévu, comme second système de contact, une bande élastique conductrice.

FIG 1

# FIG 2

EP 0 200 054 B1